# EUROPÄISCHE PATENTSCHRIFT

(11) **EP 0 457 932 B1**
(45) Veröffentlichungstag und Bekanntmachung des Hinweises auf die Patenterteilung: **09.08.1995**
(21) Anmeldenummer: 90109584.4
(22) Anmeldetag: 21.05.1990
(51) Int. Cl.: H03J 5/24

(54) **Schaltungsanordnung zur Bereichsumschaltung in Tunern**
Circuit arrangement for band switching in tuners
Arrangement de circuit pour la commutation de bande dans un tuner

(43) Veröffentlichungstag der Anmeldung: 27.11.1991
(73) Patentinhaber: SIEMENS AKTIENGESELLSCHAFT, 80333 München (DE)
(72) Erfinder: Hohmann, Henning, D-8000 München 60 (DE)

(56) Entgegenhaltungen:
- EP-A- 0 299 578
- US-A- 4 442 548
- "ICs für die Unterhaltungselektronik" 1986, Siemens, DE

## Beschreibung

Die Erfindung betrifft eine Schaltungsanordnung zur Bereichsumschaltung in Tunern mit den Merkmalen des Oberbegriffs des Anspruches 1.

In Fernsehtunern sind üblicherweise zwei oder drei elektrisch weitgehend unabhängig voneinander betriebene Teiltuner enthalten, die die Fernsehfrequenzbereiche in den VHF-Bändern und im UHF-Band abdecken.

Herkömmliche Tuner benutzen für die zwei oder drei VHF-Bereiche gemeinsame Schwingkreise, deren Teilinduktivitäten für die Bereichsumschaltung mittels gleichspannungsgesteuerter Schalterdioden umgeschaltet werden. Die Umschaltung zwischen dem VHF- und dem UHF-Bereich wird mittels pnp-Schaltertransistoren durchgeführt, die mit ihren Emittern an die Versorgungsspannungsklemme geschaltet sind und an deren Kollektoren die Teiltuner liegen. Die Basisanschlüsse sind mit Schaltausgängen einer integrierten Schaltung, im allgemeinen einer PLL-Schaltung, verbunden. Diese Schaltausgänge sind strombegrenzte Open-Kollektor-Ausgänge, die bei der Auswahl eines Bereichs durch die Bedienelemente des Fernsehgerätes niederohmig werden und über den entsprechenden Schaltertransistor den Teiltuner mit Spannung versorgen. Eine interne Strombegrenzung in der integrierten Schaltung verhindert dabei einen zu hohen Basisstrom des Schaltertransistors. Die Umschaltung der VHF-Bereiche erfolgt dadurch, daß der von der integrierten Schaltung angesteuerte Schaltertransistor die zur Aktivierung der Schalterdioden notwendigen Ströme aufbringt.

Hyperbandtuner, also Tuner die auch das in Kabelnetzen verteilte Hyperband mit dem Frequenzbereich 300 bis 470 MHz abdecken, bestehen in der Regel aus drei elektrisch unabhängigen Teiltunern. Die Band- oder Bereichsumschaltung der abgestimmten Schwingkreise wird wegen der großen abzustimmenden Frequenzbereiche in der Regel nicht mit Schalterdioden durchgeführt. Dagegen werden direkt am Antenneneingang Schalterdioden eingesetzt, die nur den gerade ausgewählten Bereich an den Antennenanschluß des Fernsehgerätes schalten. Die Umschaltung der Teiltuner und der Schalterdioden erfolgt - wie oben beschrieben - mittels Schaltertransistoren.

In vielen Hyperbandtunern wird heute eine integrierte Schaltung eingesetzt, die für jeden Teilbereich einen Mischer und einen Oszillator enthält. In diese integrierte Schaltung ist auch eine Schalteinrichtung integriert, die durch Anlegen eines bestimmten Steuersignales, beispielsweise Spannungspegels, den gewünschten Mischer und Oszillator einschaltet. Das Steuersignal kann beispielsweise über entsprechend ausgelegte Spannungsteiler aus umgeschalteten Betriebsspannungen für die Teiltuner abgeleitet werden. Die Schaltertransistoren schalten in diesem Fall nur noch den Strom der Schalterdioden und die Betriebsspannung der Vorstufen des Tuners, in die üblicherweise MOS-Tetroden zur Verstärkung der Hochfrequenz eingesetzt werden. Zwei Schaltungsanordnungen zur Bereichsumschaltung in Fernsehtunern mit MOS-Tetroden und einer integrierten Schaltung zur VHF/UHF-Umschaltung sind beispielsweise auf den Seiten 767 und 768 des Siemens Datenbuches 1986/87 "ICs für die Unterhaltungselektronik" gezeigt.

Darüber hinaus ist ein Hyperbandtuner unter der Bezeichnung UV 816 von Philips bekannt vgl. auch EP-A-0 299 578,der keine Schaltertransistoren benötigt. Dies wird durch eine integrierte Schalteinrichtung mit nicht strombegrenzten Schaltausgängen erreicht, über die die ersten Gateanschlüsse der nicht eingeschalteten MOS-Tetroden auf Masse geschaltet werden. Damit werden diese MOS-Tetroden stromlos und verlieren ihre Verstärkung. Nur die MOS-Tetrode des aktiven Bereichs bleibt eingeschaltet, indem der dafür vorgesehene Schaltausgang der integrierten Schalteinrichtung hochohmig und damit inaktiv bleibt. Nachteilig bei diesem Prinzip ist:

Ein solcher Tuner benötigt zu seiner Steuerung eine Steuereinrichtung, also z. B. einen Mikroprozessor des Fernsehgerätes, mit einer anderen Software als bei den bisher benutzten oben beschriebenen Tunern, da einerseits andere Schaltausgänge der integrierten Schalteinrichtung notwendig und andererseits eine in ihrer Polarität entgegengesetzte Schaltlogik eingesetzt werden muß. Damit ist ein solcher Tuner zu den bisher bekannten Tunern nicht kompatibel.

Die von diesen Tunern benutzten Schaltausgänge der integrierten Schaltung können nicht zusätzlich - entgegen dem heute üblichen Standard - für Schaltaufgaben außerhalb des Tuners genutzt werden.

Der Erfindung liegt die Aufgabe zugrunde, eine Schaltungsanordnung zur Bereichsumschaltung in Tunern anzugeben, die mit den bisherigen Tunern funktions- und softwarekompatibel und deren Schaltungsaufwand und Platzbedarf gegenüber den bisher bekannten Schaltungen reduziert ist.

Diese Aufgabe wird durch eine Schaltungsanordnung nach den Merkmalen des Patentanspruchs 1 gelöst. Weiterbildungen der Erfindung sind in den Unteransprüchen angegeben.

Die Erfindung wird im folgenden anhand von zwei Figuren beispielhaft für die Bereichsumschaltung zum VHF I-Bereich näher erläutert. Für die anderen Bereiche, z. B. VHF II und UHF, sind die Schaltungsanordnungen analog aufgebaut. Es zeigen:
- FIG 1: eine bekannte Schaltungsanordnung zur Bereichsumschaltung in Tunern mit Schaltertransistoren und
- FIG 2: eine erfindungsgemäße Schaltungsanordnung zur Bereichsumschaltung in Tunern mit MOS-Tetroden, deren Sourceanschlüsse auf Bezugspotential schaltbar sind.

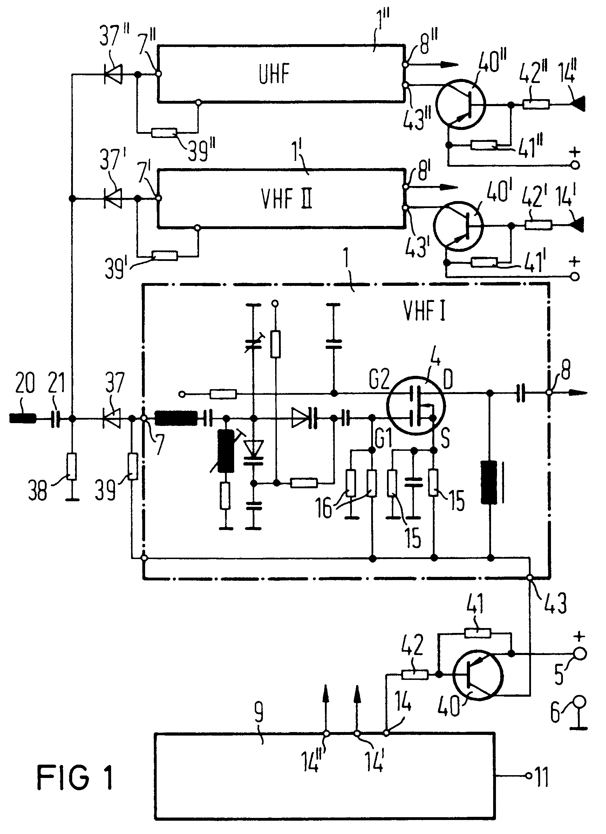

In FIG 1 ist die Eingangsstufe eines bekannten Fernsehtuners dargestellt. Die Eingangsstufe weist drei Vorstufen 1, 1′ und 1˝ mit MOS-Tetroden 4 zur Verstärkung eines an eine Klemme 20 anzulegenden Antennensignals auf. Über ein Koppelglied 21, z. B. einen Koppelkondensator, gelangt dieses Antennensignal an die Kathoden von drei Schalterdioden 37, 37′ und 37˝, deren Anoden mit jeweils einer Eingangsklemme 7, 7′, 7˝ der Vorstufen 1, 1′und 1˝ verbunden sind. An deren Ausgangsklemmen 8, 8′ und 8˝ ist ein für jeden Bereich der jeweiligen Vorstufe 1, 1′ und 1˝ hochfrequenzverstärktes Signal abgreifbar. Der besseren Übersichtlichkeit wegen ist nur die Vorstufe 1 für einen ersten Bereich, hier z. B. den VHF I-Bereich, mit seinen einzelnen Schaltungskomponenten detailliert dargestellt, wie diese an sich auch aus dem eingangs erwähnten Siemens Datenbuch 1986/87 bekannt sind. Im folgenden wird deshalb auf die Schaltungsanordnung nur insoweit eingegangen, als es für das Verständnis der Erfindung notwendig ist.

Der Sourceanschluß S der MOS-Tetrode 4 ist mit dem Verbindungspunkt eines ersten Spannungsteilers 15 und der erste Gateanschluß G1 mit dem Verbindungspunkt eines zweiten Spannungsteilers 16 zur Arbeitspunkteinstellung verbunden. Beide Spannungsteiler 15 und 16 liegen zwischen einer Bezugspotentialklemme 6 und einer Klemme 43, die über einen pnp-Schalttransistor 40 an eine Versorgungspotentialklemme 5 mit angelegter positiver Spannung schaltbar ist. Dazu ist der Kollektoranschluß dieses pnp-Schalttranistors 40 mit der Klemme 43 und dessen Basisanschluß über einen Basiswiderstand 42 an einen Schaltausgang 14 einer Schalteinrichtung 9 gelegt. Der Emitteranschluß des pnp-Schalttransistors 40 ist einerseits über einen Emitterwiderstand 41 mit dem Basisanschluß des pnp-Schalttransistors 40 und andererseits mit der Versorgungspotentialklemme 5 in Verbindung. Gesteuert wird der Schaltausgang 14 der Schalteinrichtung 9 über einen oder mehrere Steueranschlüsse 11 mittels eines oder mehrerer Steuersignale. Zusätzlich ist die Anode der Schalterdiode 37 über einen Widerstand 39 an die Klemme 43 der Vorstufe 1 angeschlossen.

Wird nach Maßgabe des oder der an den oder die Steueranschlüsse 11 angelegten Steuersignales bzw. Steuersignale der Schaltausgang 14 der Schalteinrichtung 9 bei der Auswahl des VHF I-Bereiches durch Bedienelemente im Fernsehgerät niederohmig, also auf Bezugspotential geschaltet, so schaltet der pnp-Schalttransistor 40 ein. Die positive Spannung an der Versorgungspotentialklemme 5 gelangt damit an die Klemme 43, wodurch die Vorstufe 1 an die positive Spannung gelegt und damit aktiviert wird. Zugleich wird die Schalterdiode 37 leitend, da jetzt deren Kathode negativer als deren Anode ist. Den Strom zum Schalten dieser Schalterdiode 37 liefert der pnp-Schalttransistor 40. Das an der Klemme 20 anliegende und zu verstärkende Antennensignal wird somit in der Vorstufe 1 verstärkt und steht an der Ausgangsklemme 8 zur Verfügung.

Das Umschalten auf die anderen Bereiche, hier also die beiden Vorstufen 1′ und 1˝ für den VHF II- und UHF-Bereich erfolgt in analoger Weise über die Schaltausgänge 14′ und 14˝ der Schalteinrichtung 9 wie zusätzlich noch durch die mit den Bezugszeichen 7′, 37′, 40′, 41′, 42′ und 43′ sowie 7˝, 37˝, 40˝, 41˝, 42˝ und 43˝ bezeichneten Schaltungskomponenten dargestellt ist. Gleiche Ziffern der Bezugszeichen bezeichnen dabei analoge Schaltelemente. Bei niederohmigem Schaltausgang 14′ wird also die Vorstufe 1′ aktiv, während bei niederohmigem Schaltausgang 14˝ die Vorstufe 1˝ über den dann eingeschalteten pnp-Schalttransistor 40˝ an die Versorgungspotentialklemme 5 geschaltet wird und damit als Verstärker arbeitet.

Die Schaltausgänge 14, 14′ und 14˝ der Schalteinrichtung 9 sind strombegrenzte Open-Kollektor Ausgänge. Eine Strombegrenzung in der Schalteinrichtung 9 verhindert einen zu hohen Basisstrom der pnp-Schalttransistoren 40, 40′ und 40˝.

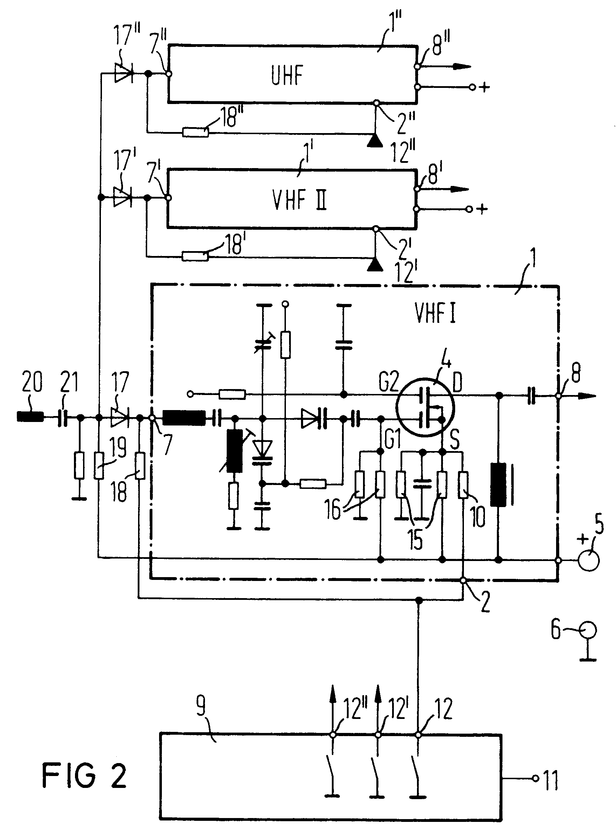

In FIG 2 ist ein Ausführungsbeispiel für eine erfindungsgemäße Schaltungsanordnung zur Bereichsumschaltung in Tunern dargestellt. Gleiche Bezugszeichen wie in FIG 1 weisen auf gleiche Schaltungselemente hin. Anders als in FIG 1 sind jetzt drei Schalterdioden 17, 17′ und 17˝ mit ihren Anoden an den Koppelkondensator 21 geschaltet und deren Kathoden mit jeweils einer Eingangsklemme 7, 7′ und 7˝ der Vorstufen 1, 1′ und 1˝ verbunden. Diese Schalterdioden 17, 17′, 17˝ sind - wie später noch erläutert wird - für die Erfindung nicht unbedingt erforderlich.

Darüber hinaus ist erfindungsgemäß im Gegensatz zu der in FIG 1 dargestellten Schaltungsanordnung der Sourceanschluß S der MOS-Tetrode 4 über einen Widerstand 10 und die Klemme 2 mit einem Schaltausgang 12 der Schalteinrichtung 9 in Verbindung.

Nach Maßgabe eines oder mehrerer an eine oder mehrere Steuerklemmen 11 der Schalteinrichtung 9 anzulegenden Steuersignals bzw. Steuersignale kann dieser Schaltausgang 12 der Schalteinrichtung 9 auf Bezugspotential geschaltet und damit mit der Bezugspotentialklemme 6 verbunden werden, wodurch die MOS-Tetrode 4 und damit die Vorstufe 1 aktivierbar ist.

Damit die MOS-Tetrode 4 ausgeschaltet ist, wenn der Schaltausgang 12 nicht auf Bezugspotential liegt, sind zwei aufeinander abgestimmte und zwischen die Versorgungspotentialklemme 5 und Bezugspotentialklemme 6 geschaltete Spannungsteiler an die MOS-Tetrode 4 geschaltet. Der erste beispielsweise aus zwei Widerständen bestehende Spannungsteiler 15 ist mit seinem Verbindungspunkt an den Sourceanschluß S und der zweite beispielsweise aus zwei Widerständen bestehende Spannungsteiler 16 mit seinem Verbindungspunkt an einen ersten Gateanschluß G1 der MOS-Tetrode 4 geschaltet. Der erste Spannungsteiler 15 und zweite Spannungsteiler 16 sind dabei so eingestellt, daß am Sourceanschluß S der MOS-Tetrode 4 eine negative Spannung erreicht wird, die einerseits groß genug ist, einen sich in der MOS-Tetrode 4 ausbildenden Kanal abzuschnüren und andererseits unterhalb der Ansprechschwelle von an den ersten Gateanschluß G1 und zweiten Gateanschluß G2 der MOS-Tetrode 4 geschaltete Schutzdioden bleibt.

Solange der Schaltausgang 12 noch nicht auf Bezugspotential geschaltet ist, ist die MOS-Tetrode 4 stromlos und eine HF-Verstärkung nicht möglich. Soll dagegen die Vorstufe 1 aktiviert werden, wird der Schaltausgang 12 der Schalteinrichtung 9 nach Maßgabe eines oder mehrerer an eine oder mehrere Eingangsklemmen 11 der Schalteinrichtung 9 anzulegende Steuersignale auf Bezugspotential geschaltet und damit der Sourceanschluß S der MOS-Tetrode 4 über den Widerstand 10 mit der Bezugspotentialklemme 6 verbunden. Dieser Widerstand 10, der zu einem Widerstand des ersten Spannungsteiler 15 parallel geschaltet ist, ist vorteilhafterweise so bemessen, daß sich der für optimale Verstärkung vorgesehene Arbeitspunkt der MOS-Tetrode 4 einstellt.

Zusätzlich ist es von Vorteil, aber nicht zwingend, daß die bereits erwähnte Schalterdiode 17 vorgesehen ist und mit ihrer Kathode an die Eingangsklemme 7 der Vorstufe 1 geschaltet und über einen im Vergleich zur Eingangsimpedanz der Vorstufe 1 hochohmigen Widerstand 18 mit dem Schaltausgang 12 der Schalteinrichtung 9 verbunden ist und daß ein dritter zwischen die Versorgungspotentialklemme 5 und Bezugspotentialklemme 6 geschaltete Spannungsteiler 19 vorgesehen ist, der mit seinem Verbindungspunkt an die Anode der Schalterdiode 17 geschaltet ist.

Diese Maßnahme bewirkt, daß - solange der Schaltausgang 12 nicht auf Bezugspotential liegt - die Schalterdiode 17 sperrt und damit an die Eingangsklemme 7 der Vorstufe 1 kein Antennensignal gelangt. Die Schalterdiode 17 sperrt diesen Bereich, da die Anode der Schalterdiode 17 durch den dritten Spannungsteiler 19 negativer als die Kathode ist, welche über einen zwischen die Kathode der Schalterdiode 17 und dem Schaltausgang 12 geschalteten Widerstand 18 sowie den Widerstand 10 am Sourceanschluß S der MOS-Tetrode 4 liegt.

Wird dagegen die Vorstufe 1 aktiviert, und damit die MOS-Tetrode 4 dieser Vorstufe 1 eingeschaltet, indem der Schaltausgang 12 der Schalteinrichtung 9 auf Bezugspotential gelegt wird, so führt die Schalterdiode 17 Strom, da deren Anodenpotential positiver als deren Kathodenpotential wird.

Die weiteren Vorstufen 1′ und 1˝ der übrigen im Tuner vorgesehen Bereiche können - wie in FIG 2 dargestellt - in gleicher Weise an weitere Schaltausgänge 12′ und 12˝ der Schalteinrichtung 9 geschaltet und über weitere Schalterdioden 17′ und 17˝ an den Koppelkondensator 21 der Antenneneingangsklemme 20 geschaltet werden. Die Schaltausgänge 12′ und 12˝ sind mit den Klemmen 2′ und 2˝ der Vorstufen 1′ und 1˝ zu verbinden, die selbst wiederum über je einen Widerstand an den Sourceanschluß der jeweiligen MOS-Tetrode der Vorstufe 1′ und 1˝ angeschlossen sind. Darüber hinaus sind auch bei diesen zwei Vorstufen 1′ und 1˝ wieder jeweils ein Widerstand 18′ und 18˝ zwischen die Kathode der Schalterdioden 17′ und 17˝ und die Eingangsklemme 2′ und 2˝ der Vorstufen 1′ und 1˝ geschaltet. Zwischen den Vorstufen 1, 1′ und 1˝ und damit den Bereichen VHF I, VHF II und UHF wird über die Schaltausgänge 12, 12′ und 12˝ der Schaltereinrichtung 9 umgeschaltet, je nach dem welcher dieser Schaltausgänge 12, 12′ und 12˝ gerade nach Maßgabe des an 11 angelegten Steuersignals an der Schalteinrichtung 9 auf Bezugspotential liegt.

Als Schalteinrichtung 9 eignet sich besonders eine integrierte Schaltung, deren für die Bereichsumschaltung notwendigen Schaltausgänge 12, 12′ und 12˝ keine Strombegrenzung aufweisen müssen. Besonders vorteilhaft dabei ist, daß die Ansteuerung der Schaltausgänge 12, 12′ und 12˝ kompatibel zur Steuersoftware der bisherigen Tuner ausgebildet sein kann. Die Schalteinrichtung 9 kann darüber hinaus beispielsweise in einer integrierten PLL (phase-locked-loop)-Schaltung enthalten sein, die z. B. alle für eine Frequenzeinstelung und Bandumschaltung notwendigen Stufen aufweist.

Es hat sich herausgestellt, daß in der Schalteinrichtung 9 vorgesehene Schalttransistoren zum Ansteuern der Schaltausgänge 12, 12′ und 12˝ so bemessen sein sollten, daß sie bei einer Spannungsfestigkeit von etwa 12 V einen Strom von etwa 25 mA schalten können.

Das Prinzip der vorliegenden Erfindung und damit die Abschaltung einer Vorstufe über das Sourcepotential einer MOS-Tetrode ist für sämtliche Tuner geeignet, insbesondere solchen mit VHF-Schwingkreisen, die mit Schalterdioden umschaltbar sind aber auch solchen, die ohne Schalterdioden arbeiten.

Der wesentlichste Vorteil der Erfindung liegt darin, daß die Schaltungsanordnung zur Bereichsumschaltung des Tuners zu den bisherigen Schaltungsanordnungen funktions- und softwarekompatibel ist und deren Schaltungsaufwand und Platzbedarf gegenüber den bisher bekannten Schaltungsanordnungen reduziert ist.

## Patentansprüche

1. Schaltungsanordnung zur Bereichsumschaltung in Tunern mit mindestens zwei Bereichen, für die jeweils eine eine MOS-Tetrode (4) aufweisende und zwischen eine Versorgungspotentialklemme (5) und Bezugspotentialklemme (6) geschaltete Vorstufe (1, 1′, 1˝) mit einer Eingangsklemme (7) und einer Ausgangsklemme (8) vorgesehen ist, wobei jede MOS-Tetrode (4) über eine Schalteinrichtung (9) aktivierbar ist,
**dadurch gekennzeichnet,**
daß mindestens die MOS-Tetrode (4) der jeweiligen Vorstufe (1, 1′, 1˝) mit ihrem Sourceanschluß (S) über einen Widerstand (10) an einen an die Bezugspotentialklemme (6) schaltbaren Schaltausgang (12, 12′, 12˝) der Schalteinrichtung (9) geschaltet ist.

2. Schaltungsanordnung nach Anspruch 1,
**dadurch gekennzeichnet,**
daß ein erster zwischen die Versorgungspotentialklemme (5) und Bezugspotentialklemme (6) geschalteter Spannungsteiler (15) mit seinem Verbindungspunkt an den Sourceanschluß (S) und ein zweiter zwischen die Versorgungspotentialklemme (5) und Bezugspotentialklemme (6) geschalteter Spannungsteiler (16) mit seinem Verbindungspunkt an einen ersten Gateanschuß (G1) der MOS-Tetrode (4) geschaltet ist, wobei der erste Spannungsteiler (15) und zweite Spannungsteiler (16) so gewählt sind, daß am Sourceanschluß (S) eine negative Spannung erreicht wird, die einerseits groß genug ist, einen in der MOS-Tetrode (4) sich ausbildenden Kanal abzuschnüren und andererseits unterhalb der Ansprechschwelle von an den ersten Gateanschluß (G1) und zweiten Gateanschluß (G2) der MOS-Tetrode (4) geschaltete Schutzdioden bleibt.

3. Schaltungsanordnung nach Anspruch 1 oder 2,
**dadurch gekennzeichnet,**
daß eine Schalterdiode (17) mit ihrer Kathode an die Eingangsklemme (7) der Vorstufe (1) geschaltet und über einen im Vergleich zur Eingangsimpedanz der Vorstufe (1) hochohmigen Widerstand (18) mit dem Signalausgang (12) der Schalteinrichtung (9) verbunden ist und daß ein dritter zwischen die Versorgungspotentialklemme (5) und Bezugspotentialklemme (6) geschalteter Spannungsteiler (19) vorgesehen ist, der mit seinem Verbindungspunkt an die Anode der Schalterdiode (17) geschaltet ist, wobei die Anode über ein Koppelglied (21) mit einer Klemme (20) zur Einspeisung eines HF-Signales verbunden ist.

4. Schaltungsanordnung nach einem der Ansprüche 1 bis 3,
**dadurch gekennzeichnet,**
daß die Schalteinrichtung (9) als integrierte Schaltung ausgebildet ist.

5. Schaltungsanordnung nach Anspruch 4,
**dadurch gekennzeichnet,**
daß die integrierte Schaltung sämtliche für eine Frequenzeinstellung und Bereichsumschaltung notwendigen Stufen aufweist.

6. Schaltungsanordnung nach einem der Ansprüche 1 bis 5,
**dadurch gekennzeichnet,**
daß der an den Sourceanschluß (S) der MOS-Tetrode (4) geschaltete Widerstand (10) so bemessen ist, daß sich der für optimale Verstärkung vorgesehene Arbeitspunkt der MOS-Tetrode (4) einstellt.

## Claims

1. Circuit arrangement for band changing in tuners having at least two bands, for which in each case one input stage (1, 1′, 1˝) is provided which has an MOS tetrode (4), is connected between a supply potential terminal (5) and a reference potential terminal (6) and has an input terminal (7) and an output terminal (8), it being possible to activate each MOS tetrode (4) via a switching device (9), characterized in that at least the MOS tetrode (4) of the respective input stage (1, 1′, 1˝) is connected by means of its source connection (S), via a resistor (10), to a switching output (12, 12′, 12˝), which can be connected to the reference potential terminal (6), of the switching device (9).

2. Circuit arrangement according to Claim 1, characterized in that a first voltage divider (15), which is connected between the supply potential terminal (5) and the reference potential terminal (6), is connected by means of its junction point to the source connection (S), and a second voltage divider (16), which is connected between the supply potential terminal (5) and the reference potential terminal (6), is connected by means of its junction point to a first gate connection (G1) of the MOS tetrode (4), the first voltage divider (15) and the second voltage divider (16) being selected such that a negative voltage is achieved at the source connection (S), which negative voltage is, on the one hand, high enough to cut off a channel which forms in the MOS tetrode (4) and, on the other hand, remains below the response threshold of protective diodes which are connected to the first gate connection (G1) and the second gate connection (G2) of the MOS tetrode (4).

3. Circuit arrangement according to Claim 1 or 2, characterized in that a switch diode (17) is connected by means of its cathode to the input terminal (7) of the input stage (1) and is connected via a resistor (18), whose resistance is high in comparison with the input impedance of the input stage (1), to the signal output (12) of the switching device (9), and in that a third voltage divider (19) is provided which is connected between the supply potential terminal (5) and the reference potential terminal (6) and is connected by means of its junction point to the anode of the switch diode (17), the anode being connected via a coupling element (21) to one terminal (20) for supplying an RF signal.

4. Circuit arrangement according to one of Claims 1 to 3, characterized in that the switching device (9) is designed as an integrated circuit.

5. Circuit arrangement according to Claim 4, characterized in that the integrated circuit has all the stages necessary for frequency setting and band changing.

6. Circuit arrangement according to one of Claims 1 to 5, characterized in that the resistor (10), which is connected to the source connection (S) of the MOS tetrode (4), is dimensioned such that that operating point of the MOS tetrode (4) is set which is intended for optimum gain.

## Revendications

1. Montage de changement de domaine dans des tuners ayant au moins deux domaines, pour chacun desquels il est prévu une tête (1,1′,1˝) radio-fréquence, qui comporte une tétrode (4) MOS, qui est branchée entre une borne (5) de potentiel d'alimentation et une borne (6) de potentiel de référence et qui comprend une borne (7) d'entrée et une borne (8) de sortie, chaque tétrode (4) MOS pouvant être activée par un dispositif (9) d'interruption,
caractérisé en ce que
au moins la tétrode (4) MOS de la tête (1,1′,1˝) est branchée par sa borne (S) de source par l'intermédiaire d'une résistance (10) à une sortie (12,12′,12˝) d'interruption du dispositif (9) d'interruption pouvant être branchée à la borne (6) de potentiel de référence.

2. Montage suivant la revendication 1,
caractérisé en ce
qu'un premier diviseur (15) de tension branché entre la borne (5) de potentiel d'alimentation et la borne (6) de potentiel de référence est branché par son point de liaison à la borne (S) de source et un deuxième diviseur (16) de tension branché entre la borne (5) de potentiel d'alimentation et la borne (6) du potentiel de référence est branché par son point de liaison à une première borne (G1) de grille de la tétrode (4) MOS, le premier diviseur (15) de tension et le deuxième diviseur (16) de tension étant choisis, de sorte à atteindre sur la borne (S) de source une tension négative, qui est d'une part suffisamment grande pour pincer un canal se formant dans la tétrode (4) MOS et qui, d'autre part, reste inférieure au seuil de réponse de diodes de protection branchées à la première borne (G1) de grille et à la deuxième borne (G2) de grille de la tétrode (4) MOS.

3. Montage suivant la revendication 1 ou 2,
caractérisé en ce
qu'une diode (17) d'interruption est branchée par sa cathode à la borne (7) d'entrée de la tête (1) radio-fréquence et est reliée par l'intermédiaire d'une résistance (18) de grande valeur ohmique par rapport à l'impédance d'entrée de la tête (1) radio-fréquence, à la sortie (12) de signaux du dispositif (9) d'interruption, et il est prévu un troisième diviseur (19) de tension, qui est branché entre la borne (5) de potentiel d'alimentation et la borne (6) de potentiel de référence et qui est branché par son point de liaison à l'anode de la diode (17) d'interruption, l'anode étant reliée par l'intermédiaire d'un élément (21) de couplage à une borne (20) d'introduction d'un signal haute fréquence.

4. Montage suivant l'une des revendications 1 à 3,
caractérisé en ce
que le dispositif (9) d'interruption est réalisé sous la forme d'un circuit intégré.

5. Montage suivant la revendication 4, caractérisé en ce que le circuit intégré comporte tous les étages nécessaires à un réglage de fréquence et à un changement de domaine.

6. Montage suivant l'une des revendications 1 à 5,
caractérisé en ce
que la résistance (10) branchée à la borne (S) de source de la tétrode (4) MOS est dimensionnée, de telle sorte que le point de fonctionnement de la tétrode (4) MOS prévu pour une amplification optimale s'établisse.
